# EUROPÄISCHE PATENTSCHRIFT

(11) **EP 1 474 826 B1**
(45) Veröffentlichungstag und Bekanntmachung des Hinweises auf die Patenterteilung: **02.11.2006**
(21) Anmeldenummer: 03739441.8
(22) Anmeldetag: 23.01.2003
(51) Int. Cl.: H01L 21/331, H01L 29/32

(54) **POLYSILIZIUM-BIPOLARTRANSISTOR UND VERFAHREN ZUR HERSTELLUNG DESSELBEN**
POLYSILICON BIPOLAR TRANSISTOR AND METHOD FOR PRODUCING THE SAME
TRANSISTOR BIPOLAIRE EN POLYSILICIUM ET PROCEDE DE PRODUCTION DE CE TRANSISTOR

(30) Priorität: 12.02.2002 DE 10205712
(43) Veröffentlichungstag der Anmeldung: 10.11.2004
(73) Patentinhaber: Infineon Technologies AG, 81669 München (DE)
(72) Erfinder: RUDOLPH, Uwe, 01157 Dresden (DE); SECK, Martin, 81827 München (DE); TILKE, Armin, 12533 Hopewell Junction New York (US)
(74) Vertreter: Schoppe, Fritz
(86) Internationale Anmeldenummer: PCT/EP2003/000673
(87) Internationale Veröffentlichungsnummer: WO 2003/069663

(56) Entgegenhaltungen:
- WO-A-98/57367
- FR-A- 2 805 924
- US-A1- 2001 051 413

## Beschreibung

Die vorliegende Erfindung bezieht sich auf Halbleiterbauelemente und deren Herstellung, und insbesondere auf Polysilizium-Bipolartransistoren mit verbesserter Basisanschlußarchitektur und deren Herstellung.

Moderne integrierte Bipolarschaltungen zeichnen sich durch eine hohe Schaltgeschwindigkeit, hohe Transitfrequenzen, gute Treibereigenschaften, eine große Steilheit der Transistoren und durch eine hohe Konstanz der Steuerspannung aus. Aufgrund dieser Eigenschaften hat die Bipolartechnologie einen hohen Stellenwert in der Mikroelektronik. Mit den bisher herkömmlichen Herstellungsprozessen integrierter Bipolarschaltungen kann derzeit beispielsweise eine Verarbeitung von Datenraten von mehr als 10 Gbit/s erreicht werden, wobei unter Ausnutzung der Polysilizium-Emitter- und -Basis-Technologie derzeit Bipolartransistoren mit implantierter Basis mit Transitfrequenzen von 30 GHz realisiert werden können.

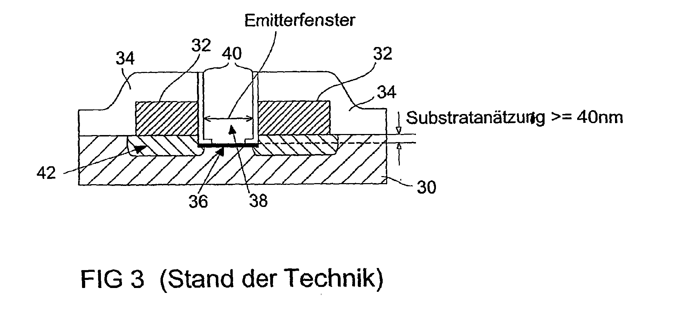

Für gute elektrische Eigenschaften von Polysilizium-Bipolartransistoren ist unter anderem die Basisanschlußstruktur entscheidend. Bei einer Basisanschlußstruktur eines herkömmlichen Polysilizium-Bipolartransistors, wie sie in Fig. 3 beispielhaft dargestellt ist, wird im allgemeinen auf einem einkristallinen Siliziumsubstrat 30, in dem der Kollektorbereich ausgebildet ist, eine Polysiliziumschicht 32 aufgebracht, die nach deren Strukturierung als Basisanschlußbereich wirksam ist. Über der Polysiliziumschicht 32 wird im allgemeinen eine Isolationsschicht 34, z. B. Siliziumoxid, aufgebracht. Bei Doppel-Polysilizium-Bipolartransistoren mit einem implantierten Basisbereich 36 wird üblicherweise ein sogenanntes Emitterfenster 38 gebildet, wobei dieses Emitterfenster 38 vorgesehen ist, um einerseits den aktiven Emitterbereich des Bipolartransistors in dem Siliziumsubstrat 30 und andererseits den Emitteranschluß für diesen Bereich zu bilden. Das Emitterfenster 38 wird dabei erzeugt, indem durch die Isolationsschicht 34 und nachfolgend durch das als Basisanschlußbereich wirksame Polysiliziummaterial 32 geätzt wird. Da nun das Polysiliziummaterial 32 des Basisanschlußbereichs direkt auf dem einkristallinen Siliziumsubstrat 30 liegt, kann man wegen der fehlenden Ätzselektivität zwischen dem polykristallinen Siliziummaterial 32 und dem einkristallinen Halbleitermaterial des Siliziumsubstrats 30 den Ätzvorgang nicht abrupt auf dem einkristallinen Siliziumsubstrat 30 stoppen.

Daher wird aufgrund der sich ergebenden Schichtdickenschwankungen der zu ätzenden Polysilizium- bzw. Isolationsschichten sowie aufgrund von Ätzratenunterschieden über dem Siliziumwafer eine deutliche Substratanätzung im Bereich des Emitterfensters 38 in einer Größenordnung von etwa 40 nm vorgesehen, um mit Sicherheit auf jedem Siliziumwafer und überall auf den verschiedenen zu prozessierenden Siliziumwafern durch die polykristalline Basisanschlußschicht zu ätzen. In dem Bereich des Emitterfensters 38 wird nun in dem Siliziumsubstrat 30 der aktive Basisbereich 36 des Bipolartransistors implantiert, der im folgenden als der "intrinsische" Basisbereich bezeichnet wird. Im folgenden wird nun ein Innenspacer 40 (spacer = Abstandsstück) geeigneter Breite in dem Emitterfenster 38 abgeschieden bzw. strukturiert. Der Innenspacer 40 hat dabei die Aufgabe, einerseits den Emitterbereich des Bipolartransistors und den Bereich des Emitteranschlusses zu definieren und andererseits eine elektrische Isolation des Emitteranschlußbereichs von dem Basisanschlußbereich vorzusehen.

Den Basisanschluß, d. h. die elektrische Verbindung zwischen dem implantierten "intrinsischen" Basisbereich 36 und der Basisanschlußschicht 32 aus einem Polysiliziummaterial, das im allgemeinen hochdotiert ist, erhält man nun durch eine Ausdiffusion von Dotierstoffatomen aus dem hochdotierten Polysiliziummaterial der Basisanschlußschicht 32 in das Siliziumsubstrat 30. Dieser durch eine Ausdiffusion von Dotierstoffatomen aus dem Polysiliziummaterial der Basisanschlußschicht 32 in das Siliziumsubstrat 30 erhaltene, dotierte Bereich wird im folgenden als der "extrinsische" Basisanschlußbereich 42 bezeichnet.

Vor der lateralen Ausdiffusion des extrinischen Basisanschlußbereichs 42 in Richtung des intrinsischen Basisbereichs 36 muß nun wegen der erforderlichen Substratanätzung zuerst in die Tiefe des Substratmaterials 30 diffundiert werden, um eine elektrische Verbindung über den extrinsischen Basisanschlußbereich 42 zwischen der Basisanschlußschicht 32 und dem intrinsischen Basisbereich 36 des Bipolartransistors herzustellen.

Bei dem im Stand der Technik bekannten Herstellungsverfahren ist eine Eindiffusion der Dotierungsatome von zumindest 150 nm in die Tiefe, d. h. in das Siliziumsubstrat 30, erforderlich ist, da man bei dem Diffusionsvorgang die Substratanätzung von etwa 40 nm und die Spacerlänge von etwa 100 - 150 nm einschließlich der Ätzratenschwankungen in der Ätztiefe zu überbrücken hat, um die erforderliche Diffusionstiefe zu erhalten. Der Basisanneal-Vorgang muß daher bei einer relativ hohen Temperatur von etwa 1050°C - 1100°C durchgeführt werden.

Somit ist für diesen Ausdiffusionsvorgang ein relativ hohes Temperaturbudget (1050°C - 1100°C) und damit eine relativ hohe Temperaturbelastung für die Halbleiterstruktur erforderlich, wobei zudem der Anschluß, d. h. die elektrische Verbindung, des extrinsischen Basisanschlußbereichs 42 mit dem intrinsischen Basisbereich 36 relativ schlecht kontrollierbar ist. Dies führt zu einer relativ schlechten Reproduzierbarkeit der elektrischen Eigenschaften der Halbleiterstruktur, d. h. insbesondere der Basisstruktur, eines herkömmlichen Polysilizium-Bipolartransistors. Dadurch können sich beispielsweise störende Streuungen der Werte des Basisanschlußwiderstands von herkömmlichen Polysilizium-Bipolartransistoren ergeben.

Wie oben beschrieben, wird das Emitterfenster 38 eines Polysilizium-Bipolartransistors mit implantierter Basis beispielsweise mittels einer Festzeitätzung durch das Polysiliziummaterial der Basisanschlußschicht 32 geätzt, wobei ferner mittels einer geeignet gewählten Überätzung in das einkristalline Siliziumsubstrat 30 geätzt wird. Eine weitere Möglichkeit, das Emitterfenster 38 eines Polysilizium-Bipolartransistors mit implantierter Basis zu strukturieren, besteht darin, eine Endpunkterkennung des Ätzvorgangs und eine geeignet gewählte Überätzung in das einkristalline Siliziumsubstrat 30 vorzunehmen. In beiden oben genannten Fällen ist es erforderlich, daß zum Ausgleich von Schichtdickenschwankungen und Ätzratenunterschieden über dem Siliziumwafer das Siliziumsubstrat 30 deutlich angeätzt wird. Dieses Anätzen kann jedoch zu Rauhigkeiten in dem Substratmaterial führen, wodurch im Extremfall eine inhomogene Grenzfläche im Emitter oder eine inhomogene Basisweite und damit eine inhomogene Stromverteilung in dem Bipolartransistor hervorgerufen werden kann.

Damit können sich wichtige Kennzahlen, wie z. B. das Produkt aus der Grenzfrequenz f_{T} und der Durchbruchspannung U_{CE0} oder das Produkt aus Stromverstärkung und Earlyspannung verschlechtern.

Diese im Stand der Technik auftretenden Probleme bei der Herstellung von Polysilizium-Bipolartransistoren mit implantierter Basis müssen bisher durch sehr aufwendige Kontrollmaßnahmen bei der Emitterfensterätzung minimiert werden.

Ferner ist es bei der Herstellung von Polysilizium-Bipolartransistoren bisher erforderlich gewesen, aufgrund der notwendigen Anätzung des Siliziumsubstrats und des dadurch tiefer liegenden Basisbereichs in dem Siliziumsubstrat ausgehend von dem hochdotierten Polysiliziummaterial der Basisanschlußschicht einen relativ tiefen extrinsischen Basisanschlußbereich in das einkristalline Siliziumsubstrat einzudiffundieren, wobei dies beispielsweise mittels eines Tempervorgangs vorgenommen wird. Um den Dotierstoff, z. B. Bor, Phosphor oder Arsen usw., aus dem Polysiliziummaterial der Basisanschlußschicht ausreichend tief in das einkristalline Siliziumsubstrat ausdiffundieren zu können, ist folglich ein relativ hohes Temperaturbudget erforderlich und damit eine relativ hohe Temperaturbelastung des Halbleiterbauelements bei dessen Herstellung nicht zu vermeiden. Dies ist jedoch insbesondere bei modernen BiCMOS-Technologien äußerst problematisch.

Durch das im Stand der Technik erforderliche Anätzen des Siliziummaterials des Substratbereichs und der damit verbundenen Probleme bei der elektrischen Verbindung der Polysilizium-Basisanschlußschicht mit dem intrinsischen Basisbereich können sich also störende Streuungen der Werte des Basisanschlußwiderstands von herkömmlichen Polysilizium-Bipolartransistoren ergeben. Außerdem werden die oben genannten elektrischen Charakteristika von Bipolartransistoren, wie z. B. deren Grenzfrequenz, Durchbruchspannung, Stromverstärkung und Earlyspannung, durch die sich ergebende Rauhigkeit des angeätzten Siliziumsubstrats negativ beeinflußt.

Ausgehend von diesem Stand der Technik besteht die Aufgabe der vorliegenden Erfindung darin, ein verbessertes Konzept zur Herstellung einer Halbleiterstruktur, insbesondere einer Basisanschlußstruktur für einen Polysilizium-Bipolartransistor und eines Polysilizium-Bipolartransistors zu schaffen.

Diese Aufgabe wird durch ein Verfahren zur Erzeugung einer Basisanschlußstruktur für einen Bipolartransistor gemäß Anspruch 1, durch eine Basisanschlußstruktur für einen Bipolartransistor gemäß Anspruch 7, durch einen Bipolartransistor gemäß Anspruch 11 und durch ein Verfahren zur Erzeugung einer Halbleiterstruktur gemäß Anspruch 12 gelöst.

Bei dem erfindungsgemäßen Verfahren zur Erzeugung einer Basisanschlußstruktur für einen Bipolartransistor wird eine Ätzstoppschicht auf ein einkristallines Halbleitersubstrat aufgebracht, eine polykristalline Basisanschlußschicht auf der Ätzstoppschicht erzeugt, und ein Emitterfenster in der Basisanschlußschicht unter Verwendung der Ätzstoppschicht als Ätzstopp geätzt.

Die erfindungsgemäße Basisstruktur für einen Bipolartransistor umfaßt dabei einen dotierten Basisanschlußbereich in einem einkristallinen Halbleitersubstrat und eine auf dem dotierten Basisanschlußbereich angeordnete dotierte polykristalline Basisanschlußschicht, wobei zwischen dem dotierten Basisanschlußbereich und der Basisanschlußschicht eine Zwischenschicht angeordnet ist, die eine elektrisch leitfähige Verbindung zwischen dem dotierten Basisanschlußbereich und der Basisanschlußschicht liefert, und aus einem Material besteht, das als Ätzstopp für ein Ätzen der Basisanschlußschicht verwendbar ist.

Der vorliegenden Erfindung liegt nun die Erkenntnis zugrunde, daß bei der Herstellung eines Polysilizium-Bipolartransistors, d. h. insbesondere bei der Herstellung der Basisanschlußstruktur desselben, durch das Vorsehen einer dünnen Ätzstoppschicht auf dem einkristallinen Siliziumsubstrat bei der Herstellung des Polysilizium-Bipolartransistors die unerwünschte und nachteilige Anätzung des Siliziumsubstratmaterials vermieden werden kann, wie es beim bisherigen Stand der Technik erforderlich war. Wenn diese Ätzstoppschicht, z. B. eine Siliziumoxidschicht, hinreichend dünn gewählt ist, können ferner die Dotierstoffe, wie z. B. Bor, Phosphor oder Arsen, während der Temperaturbehandlung (Tempern) aus dem dotierten Polysiliziummaterial der Basisanschlußschicht ohne nennenswerte Beeinflussung durch diese Schicht in das Siliziumsubstratmaterial diffundieren und sofort lateral den extrinsischen Basisanschlußbereich bilden. Damit wird eine Verbindung zum intrinsischen Basisbereich des Bipolartransistors hergestellt. Ferner kann bei dieser Temperaturbehandlung gleichzeitig das bereits beschriebene Ausheilen (Annealing) des implantierten Basisbereichs vorgenommen werden.

Bei dem erfindungsgemäßen Herstellungsverfahren reicht ein bedeutend geringerer Temperaturaufwand und damit eine deutlich geringere Temperaturbelastung aus, um während des Herstellungsverfahrens des Polysilizium-Bipolartransistors den extrinsischen Basisanschlußbereich auszudiffundieren und so die elektrische Verbindung zwischen der Basisanschlußschicht und dem intrinsischen Basisbereich des Bipolartransistors herzustellen. Es ist in diesem Zusammenhang zu beachten, daß eine immer geringere Temperaturbelastung insbesondere bei modernen BiCMOS-Prozessen eine immer notwendigere Anforderung an die Herstellungsverfahren darstellt. BiCMOS-Technologien stellen eine Kombination von Bipolar- und CMOS-Technologien dar. Damit können in einer integrierten Schaltung die Vorteile der Bipolar- und der CMOS-Schaltungstechnik vereint werden.

Durch das erfindungsgemäße Vorsehen einer dünnen Ätzstoppschicht auf dem einkristallinen Siliziumsubstrat bei der Herstellung eines Polysilizium-Bipolartransistors wird ferner vorteilhafterweise erreicht, daß die erhaltene Transistorgeometrie sehr gut reproduzierbar wird, und damit die störende und nachteilige Streuung der Werte des Basisbahnwiderstands verringert wird.

Durch das erfindungsgemäße Vorsehen einer dünnen Ätzstoppschicht kann also sowohl bei einer Festzeitätzung als auch bei einer Ätzung mit Endpunktdetektion eine Anätzung des Siliziumsubstratmaterials vermieden werden. Dies wird erreicht, indem bei einer derartigen Ätzung des Emitterfensters des Bipolartransistors eine sehr hohe Selektivität zwischen dem Polysiliziummaterial der Basisanschlußschicht und dem Material der Ätzstöppschicht, z. B. Siliziumoxid, vorgesehen wird. Dadurch genügt eine nur sehr geringe laterale Ausdiffusion von Dotierstoffatomen, z. B. von Bor, aus dem Polysiliziummaterial der Basisanschlußschicht in das einkristalline Siliziumsubstrat, d. h. die erforderliche Eindringtiefe der Dotierstoffatome in das Siliziumsubstrat wird deutlich verringert, so daß insbesondere bei den modernen BiCMOS-Technologien die Temperaturbelastung für das Halbleiterbauelement bei dessen Herstellung stark vermindert werden kann. Dies ist besonders vorteilhaft, da moderne CMOS-Prozesse während des Herstellungsprozesses eine nur sehr geringe Temperaturbelastung zulassen.

Ferner wird die Streuung des Basisanschlußwiderstands vermindert bzw. minimiert, wobei der Basisanschlußwiderstand trotz des verringerten Temperaturaufwands bei der Herstellung des lateralen, eindiffundierten, extrinsischen Basisanschlußbereichs und der damit verbundenen geringen Ausdiffusion der Dotierstoffe niedrig gehalten werden kann. Ein niedriger Basisanschlußwiderstand ergibt sich durch eine ausreichende Überlappung im Randbereich des intrinsischen Basisbereichs mit dem eindiffundierten extrinsischen Basisanschlußbereich, wobei diese Überlappung der beiden Bereiche durch eine sog. laterale Unterdiffusion des extrinsischen Basisanschlußbereichs unter den intrinsischen Basisbereichs entsteht.

Durch das erfindungsgemäße Vorsehen einer dünnen Ätzstoppschicht entfallen zudem negative Einflüsse durch die Rauhigkeit des angeätzten Siliziumsubstratmaterials, so daß störende Substratrauhigkeiten, die im Extremfall eine inhomogene Grenzfläche im Emitterbereich oder eine inhomogene Basisweite und damit eine inhomogene Stromverteilung in dem Bipolartransistor zur Folge haben können, im wesentlichen vermieden werden.

Zusammenfassend kann also festgestellt werden, daß bei der vorliegenden Erfindung eine dünne Ätzstoppschicht zwischen dem einkristallinen Siliziumsubstratmaterial und der Polysilizium-Basisanschlußschicht vorgesehen wird, wobei die Ätzstoppschicht dabei einerseits die Verwendung einer extrem selektive Siliziumätzung ermöglicht, aber andererseits eine elektrische Verbindung zwischen der Polysilizium-Basisanschlußschicht und dem diffundierten, extrinsischen Basisanschlußbereich zuläßt. Ferner ist die Ätzstoppschicht dabei so dünn, daß die Ausdiffusion des Dotierungsstoffes, z. B. von Bor-Atomen, in das Siliziumsubstratmaterial nicht behindert oder unterdrückt wird. Dadurch kann bei der zur Herstellung eines Polysilizium-Bipolartransistors, und insbesondere dessen Basisanschlußstruktur, vorzunehmenden Emitterfensterätzung die bisher erforderliche Substratanätzung und die damit verbundenen Beeinträchtigungen des Siliziumsubstrats vermieden werden.

Das erfindungsgemäße Vorsehen einer dünnen Ätzstoppschicht ist ferner auf andere Halbleiterstrukturen anwendbar, bei deren Herstellung erfindungsgemäß folgende Verfahrensschritte durchgeführt werden. Das erfindungsgemäße Verfahren zur Erzeugung einer Halbleiterstruktur umfaßt die Schritte des Aufbringens einer Ätzstoppschicht auf einer Oberfläche eines Halbleitersubstrats, des Erzeugens einer dotierten polykristallinen Schicht auf der Ätzstoppschicht, des Ätzens der polykristallinen Schicht zum Erzeugen eines Fensters in derselben, wobei die Ätzstoppschicht als Ätzstopp dient, und des Erzeugens von dotierten Bereichen in dem Halbleitersubstrat durch Ausdiffundieren von Dotieratomen aus der verbliebenen polykristallinen Schicht durch die Ätzstoppschicht in das Halbleitersubstrat.

Bevorzugte Ausführungsbeispiele der vorliegenden Erfindung werden nachfolgend Bezug nehmend auf die beiliegenden Zeichnungen näher erläutert. Es zeigen:
- Fig. 1a-d: die verschiedenen Verfahrensschritte zur Herstellung der Basisanschlußstruktur eines Polysilizium-Bipolartransistors gemäß der vorliegenden Erfindung;
- Fig. 2a-b: elektronenmikroskopische Aufnahmen eines Emitterfensters bzw. einer Basisanschlußstruktur bei der erfindungsgemäßen Herstellung eines Polysilizium-Bipolartransistors; und
- Fig. 3: eine Basisanschlußstruktur für einen herkömmlichen Polysilizium-Bipolartransistor gemäß dem Stand der Technik.

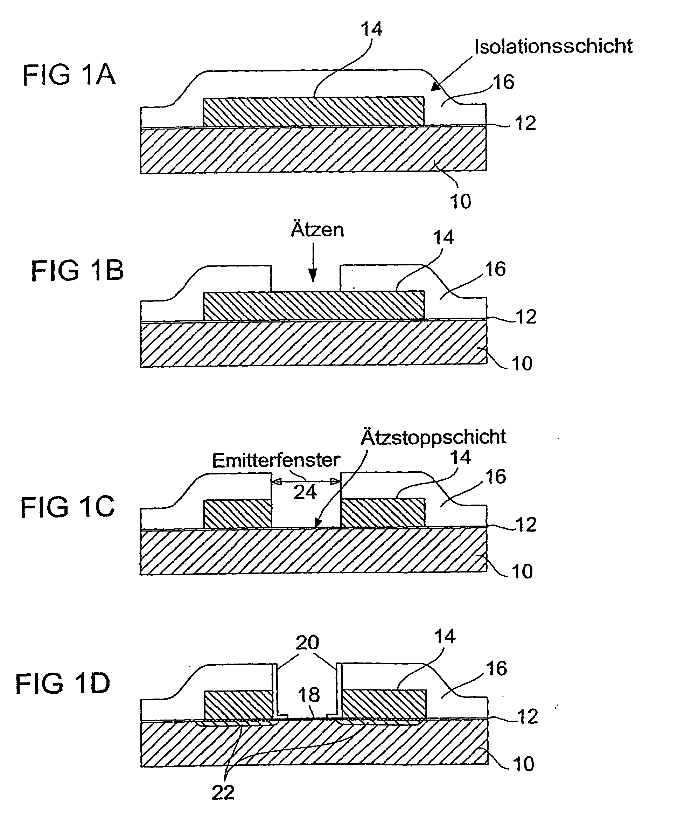

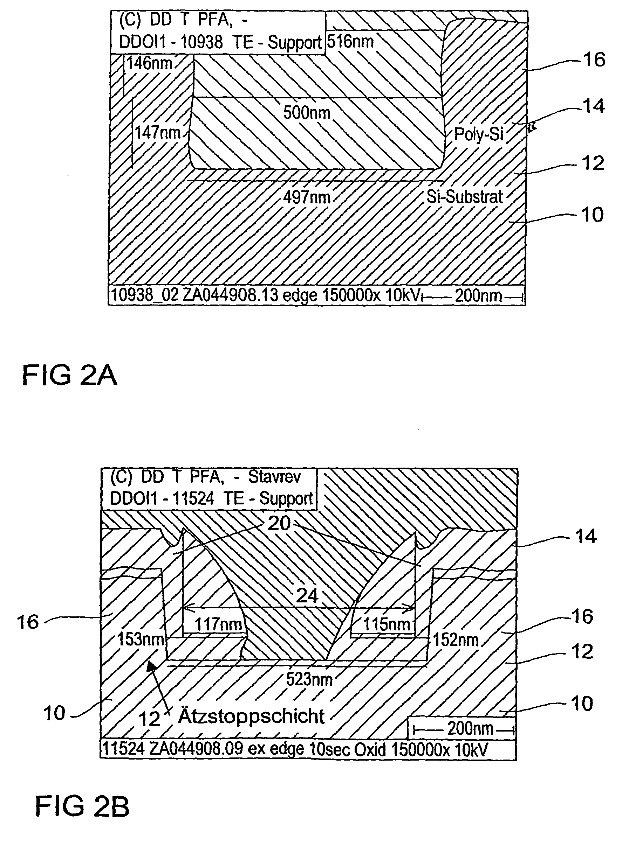

Bezug nehmend auf die Fig. 1a-d und 2a-b wird nun ein bevorzugtes Ausführungsbeispiel der vorliegenden Erfindung zur Herstellung eines Polysilizium-Bipolartransistors mit implantierter Basis und insbesondere zur Erzeugung der Basisanschlußstruktur eines Polysilizium-Bipolartransistors detailliert erörtert.

Wie in Fig. 1a dargestellt ist, wird vorzugsweise ein einkristalliner Siliziumkörper verwendet, der als Siliziumsubstrat 10 für einen Bipolartransistor dient. In dem Siliziumsubstrat 10 wird im allgemeinen eine Region eines ersten Leitfähigkeitstyps gebildet, wobei diese Region als Kollektorregion des Bipolartransistors dient. Als nächstes wird eine Ätzstoppschicht 12 auf das einkristalline Halbleitersubstrat (Siliziumsubstrat) 10 beispielsweise mittels Abscheidung aufgebracht. Auf der Ätzstoppschicht 12 wird nun eine polykristalline Schicht 14, z. B. eine Polysiliziumschicht, geeignet aufgebracht, die einen zweiten Leitfähigkeitstyp aufweist, wobei diese Schicht 14 im folgenden als Polysilizium-Basisanschlußschicht bezeichnet wird. Auf der Oberfläche der Polysilizium-Basisanschlußschicht 14 und auf der darüber hinaus noch freiliegenden Ätzstoppschicht 12 wird eine oder werden mehrere Schichten 16 aus einem Material, z. B. einem dielektrischen (isolierenden) Material, gebildet. In Fig. 1a-1d ist zur Vereinfachung der Beschreibung nur eine Isolationsschicht dargestellt ist. Es ist zu beachten, daß die in Fig. 1a vorgesehene Isolationsschicht (bzw. Isolationsschichten) optional vorgesehen ist, da diese für die vorliegende Erfindung kein wesentliches Merkmal darstellt.

Da undotierte Polysiliziumschichten sehr hochohmig sind (etwa 10⁴ Ohm cm) wird in dem vorliegenden Fall die Polysilizium-Basisanschlußschicht 14, da diese in dem Transistor eine elektrisch leitende Funktion hat, mit Dotierstoffen, z. B. Bor, Phosphor oder Arsen, versehen, um den jeweiligen Dotierungstyp, die gewünschte Dotierungsstärke und damit die gewünschte elektrische Leitfähigkeit der Polysilizium-Basisanschlußschicht 14 zu erreichen.

Um einen zusätzlichen Dotierungsschritt einzusparen, wird die Dotierung der Polysilizium-Anschlußschicht 14 im allgemeinen während der Polysiliziumabscheidung durch Beimischung geeigneter Materialien erreicht.

An stelle dieser in-situ dotierten Polysiliziumabscheidung kann aber auch eine Dotierung der Polysiliziumschicht mittels Implantation vorgenommen werden. So wird bei BiCMOS-Prozessen oft eine Polysiliziumabscheidung aus dem CMOS-Bereich mitverwendet. Dieses Polysilizium-Material kann man daher im allgemeinen nur mittels Implantation dotieren.

Im vorliegenden Fall weist nun die Polysilizium-Basisanschlußschicht 14 den zweiten Leitfähigkeitstyp auf, wobei im Zusammenhang der vorliegenden Erfindung der erste Leitfähigkeitstyp eine sogenannte n-Typ-Dotierung bezeichnet, während der zweite Leitfähigkeitstyp eine sogenannte p-Typ-Dotierung bezeichnet. Eine Dotierung in einem Halbleitermaterial wird als n-Typ bezeichnet, wenn die Majoritätsladungsträger darin Elektronen sind, wobei eine Dotierung in einem Halbleitermaterial als p-Typ bezeichnet wird, wenn die Majoritätsladungsträger darin Löcher sind. Die Leitfähigkeitstypen der Dotierungen können bei der vorliegenden Erfindung jeweils auch umgekehrt gewählt werden.

Zur Erläuterung der weiteren Schritte des erfindungsgemäßen Verfahrens zur Herstellung einer Basisanschlußstruktur für einen Polysilizium-Bipolartransistor wird nun auf die Fig. 1b und 1c Bezug genommen.

Wie in Fig. 1b und 1c dargestellt ist, werden nun die Isolationsschicht 16 (Fig. 1b) und die Polysilizium-Basisanschlußschicht 14 strukturiert, um ein sogenanntes Emitterfenster 24 bei der Herstellung eines Polysilizium-Bipolartransistors zu erzeugen. Die Strukturierung der jeweiligen Schichten erfolgt üblicherweise durch Trockenätzen der Isolationsschicht 16 und der Polysilizium-Basisanschlußschicht 14 oder durch eine entsprechende prozeßtechnische Vorgehensweisen. Wie in Fig. 1c dargestellt ist, endet der Ätzvorgang exakt an der auf dem Siliziumsubstrat aufgebrachten Ätzstoppschicht 12, so daß keine wie im Stand der Technik erforderliche Substratanätzung erfolgen muß.

Damit der Ätzvorgang abrupt an der Ätzstoppschicht 12 über dem Siliziumsubstrat 10 endet, ist eine sehr hohe Ätzselektivität zwischen dem Polysiliziummaterial der Polysilizium-Basisanschlußschicht 14 und dem Material der Ätzstoppschicht 12, z. B. Siliziumoxid, notwendig.

Ein typischer Dickenbereich für das Material der Ätzstoppschicht liegt nun beispielsweise zwischen 0,1 nm und 5 nm und vorzugsweise zwischen 0,5 - 1,0 nm. Als Materialien für die Ätzstoppschicht kommen beispielsweise thermisches Oxid oder auch chemisch gewachsenes Oxid in Frage, wobei auch beispielsweise die Verwendung von thermisch gewachsenem Nitrid möglich ist. Thermisches Oxid wird im allgemeinen mittels einer Niedertemperaturoxidation in einem Ofen oder in einer RTA-Kammer (RTA = Rapid Thermal Annealing) erzeugt. Chemisch gewachsenes Oxid wird beispielsweise mittels einer sog. oxidativen Nassclean-Behandlung erzeugt.

So bricht bei Temperaturbehandlungen um 900°C das Oxidinterface (die Oxidgrenzfläche) auf, wodurch der Kontaktwiderstand zwischen dem Polysilizium der Basisanschlußschicht 14 und dem Substratsilizium deutlich verringert wird und die Dotieratome weitestgehend ungehindert in das Siliziumsubstrat 10 eindiffundieren können. Das Dickenminimum der Ätzstoppschicht wird durch die Selektivität der Ätzung bestimmt. Bei derzeit üblichen Ätzprozessen liegt dieses Minimum beispielsweise etwa in einem Bereich um 0,5 nm (und niedriger). Die Maximaldicke der Ätzstoppschicht wird dadurch bestimmt, das die Ätzstoppschicht beim Anneal-Vorgang noch aufbricht, da sie sonst zu hochohmig wird. Das ist in der Regel beispielsweise bei etwa 1 nm (und höher) der Fall.

Alternativ zu den oben erörterten Ätzstoppschichten können allerdings prinzipiell auch leitfähige Ätzstoppschichten eingesetzt werden, die die Dotierungsatome, wie z. B. Bor-Atome, hindurch diffundieren lassen.

Es sollte natürlich beachtet werden, daß auch Schichten verwendet werden können, die beim Tempern Verspannungen erzeugen, wie dies beispielsweise bei Nitrid der Fall ist, und dadurch die Diffusion begünstigen. Aus den obigen Ausführungen wird deutlich, daß als Material für die Ätzstoppschicht neben Oxid auch andere Materialien, wie z. B. Nitrid, in Betracht kommen.

Die Dicke der Ätzstoppschicht liegt also beispielsweise in einem Bereich von 0,1 nm bis 5 nm, wobei die bei der vorliegenden Erfindung bevorzugte Dicke der Ätzstoppschicht etwa 1 nm beträgt, um die im folgenden erörterten physikalischen Eigenschaften der Ätzstoppschicht 12 zu erhalten. Es ist zu beachten, daß die erfindungsgemäße dünne Ätzstoppschicht 12 sowohl bei einer Festzeitätzung als auch bei einer Ätzung mit Endpunktdetektion eingesetzt werden kann, um eine Anätzung des Siliziummaterials des Halbleitersubstrats 10 zu vermeiden.

Zur Erläuterung der weiteren Verfahrensschritte zur Herstellung der Basisanschlußstruktur für einen Polysilizium-Bipolartransistor wird nun auf die Fig. 1d Bezug genommen.

Als nächstes wird nun im Bereich des Emitterfensters 24 die Ätzstoppschicht 12 entfernt. Im Bereich des Emitterfensters 24 liegt somit ein Abschnitt des Siliziumsubstrats 10 vor, der eine äußerst homogene und ebene Oberfläche aufweist. In dem Bereich des Emitterfensters 24, wird nun in dem Siliziumsubstrat 10 der "intrinsische" Basisbereich 18 des Polysilizium-Bipolartransistors implantiert.

Es ist natürlich auch möglich, zuerst in dem Bereich des Emitterfensters den "intrinsischen" Basisbereich 18 des Polysilizium-Bipolartransistors durch die dünne Ätzstoppschicht 12 hindurch in das Siliziumsubstrat 10 zu implantieren, und erst daraufhin die Ätzstoppschicht 12 im Bereich des Emitterfensters 24 zu entfernen.

Der Basisbereich ist bei dem vorliegenden Ausführungsbeispiel mit dem zweiten Leitfähigkeitstyp dotiert.

Bei einer Ionenimplantation wird der Dotierstoff zunächst in einem Plasma ionisiert. Die geladenen Teilchen werden mit Spannungen von typischerweise 10 kV zur Oberfläche des Siliziumsubstrats 10 hin beschleunigt und dringen typischerweise 10 nm tief ins Silizium ein. Dabei kommt es zu einer Schädigung des Siliziumgitters, und auch die Dotieratome selbst befinden sich nicht an den Gitterplätzen. Um den einkristallinen Zustand wieder herzustellen und die Dotieratome auf die Gitterplätze zu bringen, man spricht in diesem Zusammenhang von einer elektrischen Aktivierung, ist daher im allgemeinen eine Temperung bei typischerweise 900° - 1000°C erforderlich.

Im folgenden wird nun im Bereich des Emitterfensters 18 ein sogenannter "Innenspacer" 20 strukturiert. Unter Innenspacer (Spacer = Abstandsstück) versteht man eine Struktur, die sich entlang einer Stufe ausbildet. Innenspacer, die beispielsweise aus SiO₂-Material bestehen, werden in der Siliziumtechnologie dort eingesetzt, wo Strukturkanten um ein kleines Stück seitlich versetzt werden sollen bzw. wo Flanken isoliert werden sollen. Bei der vorliegenden Erfindung wird der Innenspacer 20 eingesetzt, um selbstjustierte Polysilizium-Basis- und Emitter-Bereiche bzw. -Kontakte des Polysilizium-Bipolartransistors zu erzeugen. Der Innenspacer 20 ist also vorgesehen, um einerseits die Größe des Emitterbereichs, der sich über dem Basisbereich befindet, zu definieren, um die Emitteranschlüsse zu definieren, und um die Emitteranschlüsse von der Basisanschlußschicht elektrisch zu isolieren.

Die vorliegende Halbleiterstruktur wird nun einer Temperaturbehandlung (Tempern) unterzogen, so daß aufgrund des Konzentrationsgefälles der Dotierungsstoffe zwischen der hochdotierten Polysilizium-Basisanschlußschicht 14 und dem einkristallinen Halbleiterkörper 10 zumindest einige der Dotierungsstoffe aus der hochdotierten Polysilizium-Basisanschlußschicht 14 in den einkristallinen Halbleiterkörper, d. h. in das Siliziumsubstrat 10, ausdiffundieren. Dadurch bildet sich der Basisanschlußbereich 22 in dem Siliziumsubstrat 10, d. h. insbesondere angrenzend an die Polysilizium-Basisanschlußschicht 14, aus. Es gelangt also zumindest ein Teil der Dotierungsatome des zweiten Leitfähigkeitstyps der hochdotierten Polysilizium-Basisanschlußschicht 14 in das Siliziumsubstrat 10, um angrenzend an die Polysilizium-Anschlußschicht 14 in dem Siliziumsubstrat 10 den Basisanschlußbereich 22 des zweiten Leitfähigkeitstyps zu erzeugen. Dieser Bereich wird auch als extrinsischer Basisanschlußbereich 22 bezeichnet.

Aufgrund der geringen Dicke der Ätzstoppschicht 12 können die Dotierungsatome im wesentlichen ungehindert die Ätzstoppschicht 12 durchqueren. Der extrinsische Basisanschlußbereich 22 erstreckt sich dabei ausgehend von der Grenzfläche zwischen der Polysilizium-Basisanschlußschicht 14 und dem Siliziumsubstrat 10 lateral zu dem intrinsischen Basisbereich 18 des Bipolartransistors, wobei sich vorzugsweise eine ausreichende Überlappung im Randbereich des intrinsischen Basisbereichs mit dem eindiffundierten extrinsischen Basisanschlußbereich ergibt. Dadurch entsteht eine großflächige, elektrische Verbindung mit dem intrinsischen Basisbereich 18 in dem Halbleitersubstrat 10.

Unter einer Temperaturbehandlung, bzw. Tempern, versteht man in der Siliziumtechnologie die Behandlung von Silizium bei erhöhten Temperaturen in einer inerten Atmosphäre, z. B. Stickstoff, Argon, Wasserstoff, Formiergas. Dabei wachsen zwar keine neuen Schichten auf, und es wird kein Material entfernt, aber die bereits vorhandenen Schichten und das Siliziumsubstrat selbst werden entscheidenden Veränderungen unterzogen. In dem vorliegenden Fall gelangen dadurch die Dotierstoffatome des ersten bzw. zweiten Leitfähigkeitstyps der Polysilizium-Basisanschlußschicht 14 in das angrenzende einkristalline Halbleitermaterial des Siliziumsubstrats 10.

Ferner kann nach einer Ionenimplantation eine solche Temperaturbehandlung gleichzeitig auch dazu eingesetzt werden, um den einkristallinen Zustand des Siliziumsubstrats 10 wieder herzustellen und die Dotieratome auf die Gitterplätze zu bringen (Annealing).

Durch das erfindungsgemäße Verfahren zur Erzeugung einer Basisanschlußstruktur für einen Polysilizium-Bipolartransistor kann folglich eine Basisstruktur bzw. eine Basisanschlußstruktur erzeugt werden, die einen dotierten Basisanschlußbereich 22 in einem einkristallinen Halbleitersubstrat 10 und eine auf dem dotierten Basisanschlußbereich 22 angeordnete dotierte polykristalline Basisanschlußschicht 14 aufweist, wobei zwischen dem dotierten Basisanschlußbereich 22 und der Polysilizium-Basisanschlußschicht 14 eine Zwischenschicht 12 angeordnet ist, die eine elektrisch leitfähige Verbindung zwischen dem dotierten Basisanschlußbereich 22 und der Polysilizium-Basisanschlußschicht 14 liefert und aus einem Material besteht, das als Ätzstopp für ein Ätzen der Polysilizium-Basisanschlußschicht 14 verwendbar ist.

In der polykristallinen Basisanschlußschicht ist ein Emitterfenster 24 gebildet, das einen freigelegten Bereich des einkristallinen Halbleitersubstrats 10 definiert. In diesem Bereich des Emitterfensters 24 ist durch Implantation der Basisbereich 18 eines Polysilizium-Bipolartransistors gebildet. Ferner ist der Basisanschlußbereich 22 durch Ausdiffundieren von Dotierstoffatomen aus der Polysilizium-Basisanschlußschicht 14 durch die Zwischenschicht 12 hindurch in das Halbleitersubstrat 10 gebildet ist, wobei eine elektrisch leitfähige Verbindung zwischen der Polysilizium-Basisanschlußschicht 14 und dem Basisanschlußbereich 22 und damit zu dem implantierten Basisbereich 18 besteht.

Bei der Herstellung einer elektrisch leitfähigen Verbindung zwischen der Polysilizium-Basisanschlußschicht 14 und dem Basisanschlußbereich 22 muß daher bei der vorliegenden Erfindung nur der Innenspacer 20 lateral unterdiffundiert werden, d. h. also nur etwa 70 nm - 130 nm und vorzugsweise etwa nur 90 nm - 110 nm. Ein niedriger Basisanschlußwiderstand ergibt sich dabei durch eine ausreichende Überlappung im Randbereich des intrinsischen Basisbereichs mit dem eindiffundierten extrinsischen Basisanschlußbereich. Bei diesem Diffusionsvorgang ist eine relativ niedrige Temperatur von etwa 800 - 1000°C und vorzugsweise von etwa 850 - 950°C ausreichend.

Wie bereits eingangs erläutert, muß im Gegensatz zur vorliegenden Erfindung bei dem im Stand der Technik bekannten Herstellungsverfahren der Basisanneal-Vorgang bei einer deutlich höheren Temperatur von etwa 1050°C - 1100°C durchgeführt werden, da eine Eindiffusion der Dotierungsatome von zumindest 150 nm und mehr in die Tiefe, d. h. in das Siliziumsubstrat, erforderlich ist. Diese Diffusionstiefe ergibt sich dadurch, daß man bei dem Diffusionsvorgang die Substratanätzung von etwa 40 nm und die Spacerlänge von etwa 100 - 150 nm einschließlich der Ätzratenschwankungen in der Ätztiefe zu überbrücken hat.

Zusammenfassend kann also festgestellt werden, daß die vorliegende Erfindung das Vorsehen einer dünnen Ätzstoppschicht zwischen dem einkristallinen Siliziumsubstratmaterial und der Polysilizium-Basisanschlußschicht vorschlägt, wobei die Ätzstoppschicht dabei einerseits eine extrem selektive Siliziumätzung ermöglicht und andererseits eine elektrische Verbindung zwischen der Polysilizium-Basisanschlußschicht und dem diffundierten, extrinsischen Basisanschlußbereich zuläßt. Dadurch wird die Substratanätzung bei der zur Herstellung eines Polysilizium-Bipolartransistors, und insbesondere dessen Basisanschlußstruktur, erforderliche Emitterfensterätzung vermieden. Die Ätzstoppschicht ist dabei so dünn, daß einerseits die Ausdiffusion des Dotierungsstoffes, z. B. von Bor-Atomen, in das Siliziumsubstratmaterial nicht unterdrückt wird und ferner eine elektrische Leitfähigkeit zwischen der Polysilizium-Basisanschlußschicht und dem extrinsischen, diffundierten Basisanschlußbereich nach der Ausdiffusion vorliegt.

Bei dem erfindungsgemäßen Herstellungsverfahren reicht damit ein bedeutend geringerer Temperaturaufwand aus, um den extrinsischen Basisanschlußbereich auszudiffundieren und so die elektrische Verbindung zwischen der Basisanschlußschicht und dem intrinsischen Basisbereich des Bipolartransistors herzustellen. Ferner wird die Streuung des Basisanschlußwiderstands minimiert, wobei außerdem negative Einflüsse durch die Rauhigkeit des angeätzten Siliziumsubstratmaterials entfallen, so daß störende Substratrauhigkeiten, die im Extremfall eine inhomogene Grenzfläche im Emitterbereich oder eine inhomogene Basisweite und damit eine inhomogene Stromverteilung in dem Bipolartransistor zur Folge haben können, im wesentlichen vermieden werden.

Zur Verdeutlichung der vorliegenden Erfindung sind in den Fig. 2a-b jeweils elektronenmikroskopische Aufnahmen des Emitterfensters bzw. der Basisanschlußstruktur bei der Herstellung eines Polysilizium-Bipolartransistors dargestellt. In den Fig. 2a-b sind die jeweiligen Abmessungen der verschiedenen Schichten bzw. Strukturen angegeben. Darüber hinaus zeigt Fig. 2b das Vorhandensein der als Stoppschicht wirksamen Oxidschicht 12 zwischen der Polysilizium-Basisanschlußschicht 14 und dem Halbleitersubstrat 10.

Wie aus Fig. 2b ersichtlich ist, beträgt die Dicke der Ätzstoppschicht 12, die beispielsweise aus einer dünnen Siliziumoxidschicht besteht, etwa 1 nm. Mittels dieser Schicht wird die Emitterfensterätzung definiert, d. h. exakt an der Substratoberfläche gestoppt.

Die in Fig. 2b gezeigten, relevanten Bereiche der erfindungsgemäßen Basisanschlußstruktur für einen Polysilizium-Bipolartransistors, d. h. das einkristalline Halbleitersubstrat 10 (Siliziumsubstrat), die Ätzstoppschicht 12, die polykristalline Schicht 14 (Polysilizium), die Isolationsschicht 16, der intrinsische Basisbereich 18, der Innenspacer 20 und das Emitterfenster 24, sind zur Verdeutlichung mit den bei der vorliegenden Erfindungen verwendeten Bezugszeichen versehen.

### Bezugszeichenliste:

- 10: einkristallines Halbleitersubstrat
- 12: Ätzstoppschicht
- 14: polykristalline Schicht
- 16: Isolationsschicht
- 18: intrinsischer Basisbereich
- 20: Innenspacer
- 22: Basisanschlußbereich
- 24: Emitterfenster

## Patentansprüche

1. Verfahren zur Erzeugung einer Basisanschlußstruktur für einen Bipolartransistor, mit folgenden Schritten:
Aufbringen einer Ätzstoppschicht (12) auf ein Siliziumsubstrat(10);
Erzeugen einer Polysilizium-Basisanschlußschicht (14) auf der Ätzstoppschicht (12);
Ätzen eines Emitterfensters in die Basisanschlußschicht (14) unter Verwendung der Ätzstoppschicht (12) als Ätzstopp; und
Erzeugen eines dotierten Basisanschlußbereichs (22) durch Ausdiffundieren von Dotieratomen aus der Polysilizium-Basisanschlußschicht (14) durch die Ätzstoppschicht (12) in das Siliziumsubstrat (10), wobei der Basisanschlußbereich (22) eine Tiefe von 70 nm - 130 nm und vorzugsweise von 90 nm - 110 nm aufweist, und wobei die Ätzstoppschicht (12) eine elektrisch leitfähige Verbindung zwischen dem dotierten Basisanschlußbereich (22) und der Basisanschlußschicht (14) liefert.

2. Verfahren nach Anspruch 1, bei dem der Schritt des Ausdiffundierens von Dotieratomen eine Temperaturbehandlung bei einer Temperatur in einem Bereich von 800° - 1000°C und vorzugsweise in einem Bereich von 850° - 950°C aufweist.

3. Verfahren nach Anspruch 1 oder 2, das ferner einen Schritt des Entfernens der Ätzstoppschicht (12) im Bereich des Emitterfensters und des Erzeugens eines Basisbereichs (18) durch Implantation im Bereich des Emitterfensters aufweist.

4. Verfahren nach einem der vorhergehenden Ansprüche, bei dem die Dicke der Ätzstoppschicht (12) in einem Bereich von 0,1 bis 5 nm liegt, und vorzugsweise 1 nm beträgt.

5. Basisanschlußstruktur für einen Bipolartransistor, mit folgenden Merkmalen:
einem dotierten Basisanschlußbereich (22) in einem Siliziumsubstrat (10), wobei der Basisanschlußbereich (22) eine Tiefe von 70 nm - 130 nm und vorzugsweise von 90 nm - 110 nm aufweist; und
eine auf dem dotierten Basisanschlußbereich (22) angeordnete dotierte Polysilizium-Basisanschlußschicht (14),
wobei zwischen dem dotierten Basisanschlußbereich (22) und der Basisanschlußschicht (14) eine Zwischenschicht (12) angeordnet ist, die eine elektrisch leitfähige Verbindung zwischen dem dotierten Basisanschlußbereich (22) und der Basisanschlußschicht (14) liefert und aus einem Material besteht, das als Ätzstopp für ein Ätzen der Basisanschlußschicht (14) verwendbar ist.

6. Basisanschlußstruktur nach Anspruch 5, bei der in der Polysilizium-Basisanschlußschicht (14) ein Emitterfenster gebildet ist, das einen freigelegten Bereich des Siliziumsubstrats (10) definiert.

7. Basisanschlußstruktur nach Anspruch 5 oder 6, bei der im Bereich des Emitterfensters ein Basisbereich (18) gebildet ist.

8. Basisanschlußstruktur nach einem der Ansprüche 5 bis 7, bei der der Basisanschlußbereich (22) durch Ausdiffundieren von Dotierungsatomen aus der Basisanschlußschicht (14) durch die Zwischenschicht (12) hindurch in das Siliziumsubstrat (10) gebildet ist.

9. Bipolartransistor mit einer Basisanschlußstruktur nach einem der Ansprüche 5-8.

## Claims

1. Method of producing a base terminal structure for a bipolar transistor, comprising the following steps:
applying an etch stop layer (12) on a silicon substrate (10);
producing a polysilicon base terminal layer (14) on the etch stop layer (12);
etching an emitter window in the base terminal layer (14) using the etch stop layer (12) as an etch stop; and
producing a doped base terminal region (22) by out-diffusing dopant atoms from the polysilicon base terminal layer (14) through the etch stop layer (12) into the silicon substrate (10), wherein the base terminal region (22) has a depth of 70 nm - 130nm and preferably of 90 nm - 110 nm, and wherein the etch stop layer (12) provides an electrically conductive connection between the doped base terminal region (22) and the base terminal layer (14).

2. Method according to claim 1, wherein the step of out-diffusing dopant atoms comprises a temperature treatment at a temperature in a range of 800° - 1000°C and preferably in a range of 850° - 950°C.

3. Method according to claim 1 or 2, further comprising a step of removing the etch stop layer (12) in the region of the emitter window and producing a base region (18) by implantation in the region of the emitter window.

4. Method according to one of the preceding claims, wherein the thickness of the etch stop layer (12) is in a range of 0.1 - 5 nm and preferably is 1 nm.

5. Base terminal structure for a bipolar transistor, comprising:
a doped base terminal region (22) in a silicon substrate (10), wherein the base terminal region (22) has a depth of 70 nm - 130 nm and preferably of 90 nm - 110 nm; and
a doped polysilicon base terminal layer (14) arranged on the doped base terminal region (22),
wherein, between the doped base terminal region (22) and the base terminal layer (14), an intermediate layer (12) is arranged, which provides an electrically conductive connection between the doped base terminal region (22) and the base terminal layer (14) and is made of a material which is usable as an etch stop for etching the base terminal layer (14).

6. Base terminal structure according to claim 5, wherein in the polysilicon base terminal layer (14) an emitter window is formed, which defines an exposed region of the silicon substrate (10).

7. Base terminal structure according to claim 5 or 6, wherein a base region (18) is formed in the region of the emitter window.

8. Base terminal structure according to one of claims 5 to 7, wherein the base terminal region (22) is formed by out-diffusing dopant atoms from the base terminal layer (14) through the intermediate layer (12) into the semiconductor substrate (10).

9. Bipolar transistor having a base terminal structure according to one of claims 5 - 9.

## Revendications

1. Procédé pour générer une structure de connexion de base pour un transistor bipolaire, aux étapes suivantes consistant à :
appliquer une couche d'arrêt de gravure (12) sur un substrat de silicium (10) ;
générer une couche de connexion de base en polysilicium (14) sur la couche d'arrêt de gravure (12) ;
graver une fenêtre d'émetteur dans la couche de connexion de base (14) à l'aide de la couche d'arrêt de gravure (12) comme arrêt de gravure ; et
générer une zone de connexion de base dopée (22) par diffusion d'atomes de dopage de la couche de connexion de base en polysilicium (14), à travers la couche d'arrêt de gravure (12), vers le substrat de silicium (10), la zone de connexion de base (22) présentant une profondeur de 70 nm à 130 nm et, de préférence, de 90 nm à 110 nm, et la couche d'arrêt de gravure (12) créant une connexion électriquement conductrice entre la zone de connexion de base dopée (22) et la couche de connexion de base (14).

2. Procédé selon la revendication 1, dans lequel l'étape de diffusion d'atomes de dopage présente un traitement de température à une température de l'ordre de 800° à 1000°C et, de préférence de l'ordre de 850° à 950°C.

3. Procédé selon la revendication 1 ou 2, présentant, par ailleurs, une étape consistant à éliminer la couche d'arrêt de gravure (12) à l'endroit de la fenêtre d'émetteur et à générer une zone de base (18) par implantation à l'endroit de la fenêtre d'émetteur.

4. Procédé selon l'une des revendications précédentes, dans lequel l'épaisseur de la couche d'arrêt de gravure (12) est de l'ordre de 0,1 à 5 nm et est, de préférence, de 1 nm.

5. Structure de connexion de base pour un transistor bipolaire, aux caractéristiques suivantes :
une zone de connexion de base dopée (22) dans un substrat de silicium (10), la zone de connexion de base (22) présentant une profondeur de 70 nm à 130 nm et, de préférence, de 90 nm à 110 nm ; et
une couche de connexion de base en polysilicium dopée (14) disposée sur la zone de connexion de base dopée (22),
entre la zone de connexion de base dopée (22) et la couche de connexion de base (14) étant disposée une couche intermédiaire (12) qui crée une connexion électriquement conductrice entre la zone de connexion de base dopée (22) et la couche de connexion de base (14) et est réalisée en un matériau pouvant être utilisé comme arrêt de gravure pour une gravure de la couche de connexion de base (14).

6. Structure de connexion de base selon la revendication 5, dans laquelle est formée, dans la couche de connexion de base en polysilicium (14), une fenêtre d'émetteur qui définit une zone exposée du substrat de silicium (10) .

7. Structure de connexion de base selon la revendication 5 ou 6, dans laquelle est formée, à l'endroit de la fenêtre d'émetteur, une zone de base (18).

8. Structure de connexion de base selon l'une des revendications 5 à 7, dans laquelle la zone de connexion de base (22) est formée par diffusion d'atomes de dopage de la couche de connexion de base (14), à travers la couche intermédiaire (12), vers le substrat de silicium (10).

9. Transistor bipolaire avec une structure de connexion de base selon l'une des revendications 5 à 8.
